## Europäisches Patentamt

## European Patent Office

## Office européen des brevets

(19)

(11) Veröffentlichungsnummer: **0 092 657**

**B1**

(12)

# EUROPÄISCHE PATENTSCHRIFT

(45) Veröffentlichungstag der Patentschrift:
29.06.88

(21) Anmeldenummer: **83101903.1**

(22) Anmeldetag: **24.02.83**

(51) Int. Cl.⁴: **H 03 J 5/02**, H 03 L 7/10

(54) **Schaltungsanordnung zum Abstimmen von Hochfrequenzempfängern mit einer PLL-Schaltung.**

(30) Priorität: **28.04.82 DE 3215747**

(43) Veröffentlichungstag der Anmeldung:
**02.11.83 Patentblatt 83/44**

(45) Bekanntmachung des Hinweises auf die Patenterteilung:
**29.06.88 Patentblatt 88/26**

(84) Benannte Vertragsstaaten:
**BE CH FR GB IT LI NL SE**

(56) Entgegenhaltungen:
**DE-A-2 718 472**
**FR-A-2 389 274**
**GB-A-1 444 860**
**US-A-3 729 688**

(73) Patentinhaber: **Deutsche Thomson- Brandt GmbH, Hermann- Schwer- Strasse 3 Postfach 1307, D-7730 Villingen- Schwenningen (DE)**

(72) Erfinder: **Maier, Gerhard, Reutestrasse 19, D-7735 Dauchingen (DE)**
Erfinder: **Selz, Alfred, Mühleschweg 12, D-7730 Tannheim (DE)**

## Beschreibung

Die Erfindung geht aus von einer Schaltungsanordnung zum Abstimmen von Hochfrequenzempfängern mit Hilfe einer Phase-locked-loop-Schaltung (PLL).

Bekanntlich können mit einer derartigen Anordnung sehr genaue Abstimmungen erhalten werden, da die erzeugten Oszillatorfrequenzen durch die Verwendung einer sehr hohen und konstanten Referenzfrequenz eines Quarzoszillators aus diesem abgeleitet werden. Am Ausgang der PLL-Schaltung liegt ein Operationsverstärker, welchem die Abstimmspannung entnommen wird. Vom Ausgang dieses Operationsverstärkers ist über ein RC-Glied eine Gegenkopplung für diesen eingefügt, welche für stabile Verhältnisse sorgen soll. Nun ist diese Gegenkopplung jedoch nicht über den gesamten Abstimmspannungsbereich optimal, da durch die Spannungscharakteristik der verwendeten Kapazitätsdioden die Abstimmsteilheiten unterschiedlich sind, d. h., daß im Bereich niedriger Abstimmspannung kleine Änderungen eine wesentliche größere Frequenzänderung des Oszillators zur Folge haben als bei höheren Werten der Abstimmspannung, für welche größere Änderungen notwendig sind für eine bestimme Änderung der Oszillatorfrequenz, weil der Kapazitätsdiodencharakteristikverlauf dort wesentlich flacher ist. Auf Grund dieser stark unterschiedlichen Steilheiten der Charakteristik der Kapazitätsdioden ist eine feste Dimensionierung der Gegenkopplung mit großen Nachteilen verbunden. Die Glättung der Abstimmspannung ist nicht optimal in jedem Abstimmpunkt. Als Folge ergeben sich durch periodische Veränderung der Oszillatorfrequenz Streifen im Bild oder die gesamte PLL-Schaltung wird unstabil, was sich z. B. beim Umschalten bei weit auseinander liegenden Abstimmspannungswerten bemerkbar macht.

Aus der DE-A-2 718 472 ist eine Schaltungsanordnung zum Abstimmen von Hochfrequenzempfängern bekannt, bei der durch ein Regelglied die Gegenkopplungsspannung eines Operationsverstärkers in Abhängigkeit von der Abstimmspannung verändert wird. Dabei liegt der bekannten Schaltung die Aufgabe zugrunde, eine Abstimmschaltung zu schaffen, bei der die Nichtlinearität der Abstimmsteilheit des Überlagerungsoszillators weitgehend kompensiert wird. Dabei geht diese Schaltung von einer Abstimmschaltung aus, bei welcher ein elektronischer Zähler verwendet wird zur digitalen Bestimmung der Empfangsfrequenz durch periodisches Zählen der Schwingungen wenigstens eines Überlagungsoszillators des Empfängers. Die in einem Speicher eingegebenen Abstimmwerte werden mit dem Zählerausgang verglichen und bei Gleichheit des Ergebnisses über eine Integrierschaltung wird daraufhin eine Abstimmspannung gebildet. Diese Schaltung soll die eingangs definierte Aufgabe lösen, den Verlauf der Abstimmspannung durch Regelung der Gegenkopplung zu beeinflussen.

Die vorliegende Anmeldung geht aus von einer Schaltungsanordnung zum Abstimmen von Hochfrequenzempfängern mit Hilfe einer Phase-locked-loop-Schaltung zur Erzeugung einer Abstimmspannung für die Kapazitätsdioden in den Abstimmkreisen eines HF-Empfangsgerätes. Hierbei soll im Gegensatz zur bekannten Schaltung nicht die Abstimmspannung selbst durch eine Gegenkopplung stabil gehalten werden. Es ist auch bekannt, bei einer PPL-Schaltung mit Hilfe einer Diodenwiderstandsanordnung in Abhängigkeit von der Abstimmung bzw. Frequenz die Zeitkonstante und damit die Bandbreite des Tiefpassfilters in der PLL-Schaltung umzuschalten (US-A-3 729 688). Dazu sind mehrere Tiefpassfilter vorgesehen, die in Abhängigkeit von der Abstimmung eingeschaltet werden. Für jede Umschaltung ist je ein Tiefpassfilter vorgesehen.

Der Erfindung liegt die Aufgabe zugrunde, für einen großen Abstimmspannungsbereich optimale verhältnisse für ein aktives Tiefpassfilter in der Loop-Schaltung zu schaffen, wodurch unabhängig von der Ablage der Korrektur optimale Rückkopplungsbedingungen für den Operationsverstärker des aktiven Tiefpassfilters vorliegen. Dabei soll vermieden werden, daß mehrere Tiefpassfilter vorzusehen sind. Diese Aufgabe wird durch die Maßnahme des Patentanspruchs gelöst.

Nachstehend soll die Erfindung in einem Ausführungsbeispiel mit Hilfe der Zeichnung näher erläutert werden.

Figur 1    zeigt das der Erfindung zugrunde liegende Prinzip.

Figur 2    zeigt eine Kurvendarstellung der Erläuterung der Figur 1.

Figur 3    zeigt eine detaillierte Schaltungsausführung der Erfindung.

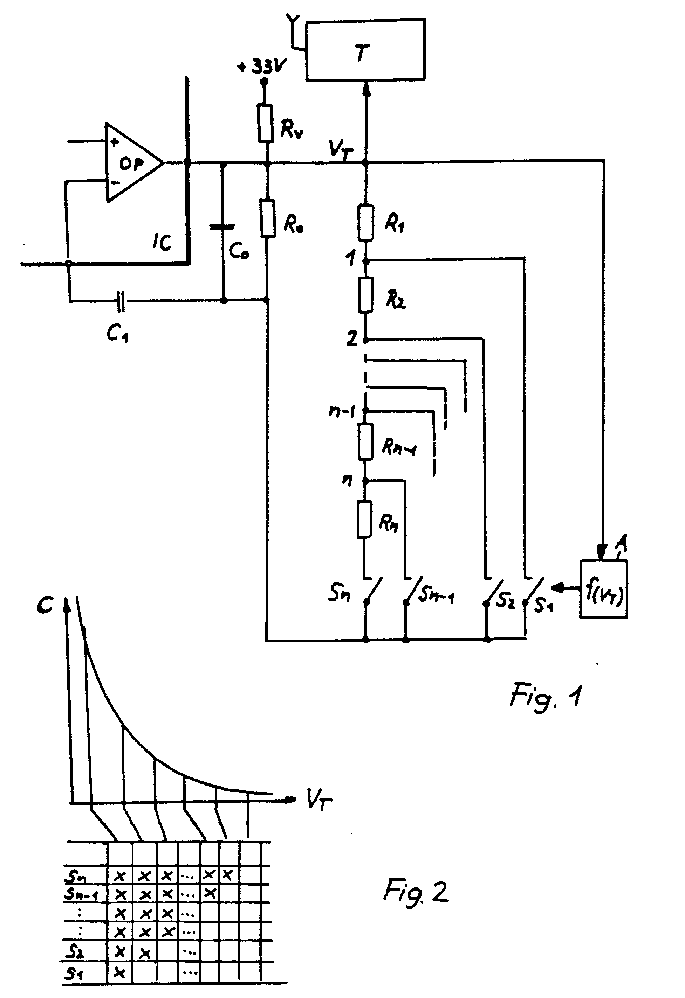

In Figur 1 liegt am Ausgang einer mit IC angedeuteten integrierten Schaltung in PLL-Technik ein Operationsverstärker OP, an dessen Ausgang die Abstimmspannung VT abnehmbar ist, die einem Tuner T zugeführt wird. Vom Ausgang des Operationsverstärkers OP ist eine Gegenkopplung, bestehend aus dem Widerstand R 0, C 0, C 1 auf den invertierenden Eingang des Operationsverstärkers OP eingeführt. Diese Anordnung stellt das Loop-Tiefpassfilter dar, welchem die Abstimmspannung entommen wird. Über den Widerstand RV liegt der Ausgang an einer stabilisierten Spannung von z. B. 33 V. Parallel zum Widerstand R 0 ist erfindungsgemäß eine Widerstandkette R 1 - R n geschaltet, deren Verbindungspunkte 1 - n über Schaltstrecken S 1 - S n mit dem Widerstand R 0 verbindbar sind. Die Schaltstrecken werden von einer Anordnung A in Abhängigkeit von der Abstimmspannung VT betätigt.

In Abhängigkeit von der Abstimmspannung, d. h. in Abhängigkeit von der eingestellten Frequenz wird die Bandbreite des Filters verändert. Bei tiefen Frequenzen, bei denen die Abstimmspannung sehr klein ist, ist der Kurvenverlauf der C/U-Charakteristik steiler als bei höheren Abstimmspannungen. Je größer die Steilheit, desto mehr können sich Störgrößen auf die mit Hilfe einer Phase-locked-loop-Schaltung erzeugten Abstimmspannung unangenehm bemerkbar machen. Das Filter in der Regelschleife muß also verschieden schnell reagieren. Der Erfindung liegt also die Erkenntnis zugrunde, daß das Tiefpaßverhalten der Filteranordnung geändert werden muß, um stabile Verhältnisse zu erhalten. Der Verlauf der Abstimmspannung wird hierbei nicht beeinflußt.

Die Abstimmspannung wird hierbei dazu verwendet, um als Kriterium für eine entsprechende Umschaltung des Tiefpaßfilters zu dienen.

In Figur 2 ist die Abhängigkeit der Kapazitätsdioden von der angelegten Abstimmspannung VT aufgezeichnet. Man erkennt den zunächst sehr steilen Verlauf bei niedrigen Abstimmspannungen, der zu höheren Werten immer flacher wird. Darunter ist in einer Tabelle für die verschiedenen n Abstimmspannungsbereiche die Schalterstellung aufgezeichnet. Die jeweils geschlossenen Schalter sind mit einem X versehen. Die Zahl n richtet sich nach der Referenzfrequenz der PLL-Schaltung und der effektiven Abstimmsteilheit der Diodenkennlinie.

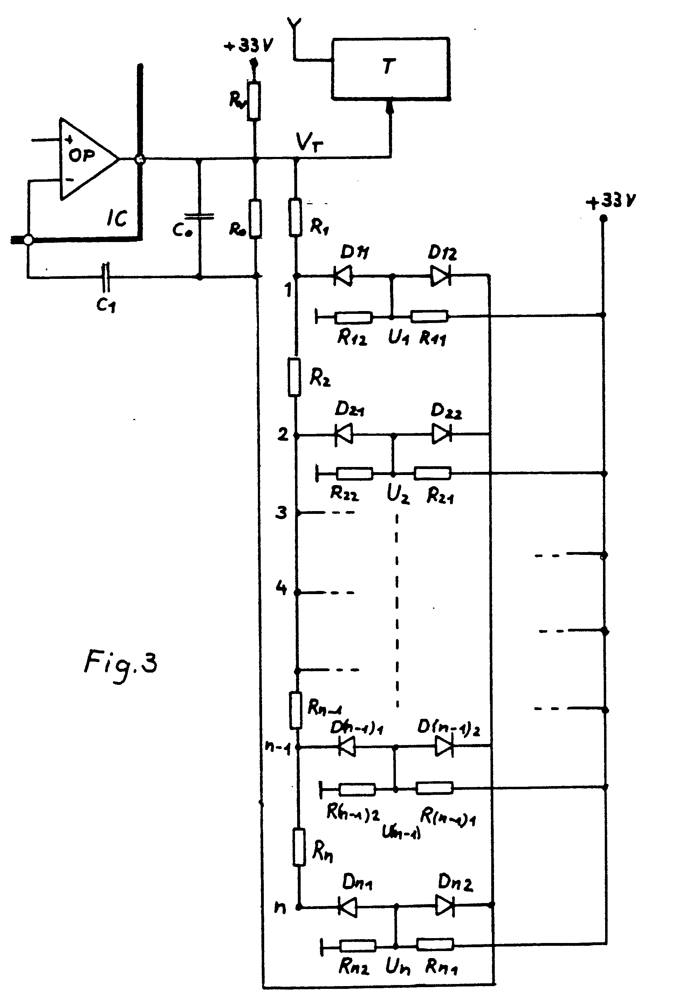

In Figur 3 wird nachfolgend eine detaillierte Schaltungsanordnung beschrieben. Dabei werden gleiche Bezugszeichen der Figur 1 verwendet. Die Schaltstrecken werden durch Dioden D 11 - D n1 sowie D 12 - D n2 dargestellt, die in Abhängigkeit von der Abstimmspannung VT nacheinander durchgeschaltet werden, sobald die an den Kathoden der Dioden liegende Spannungen den durch die Spannungsteiler R 11, R 12 - R n1, R n2 gebildeten Vorspannungen U 1 - U n unterschritten werden.

Die Wirkungsweise der Schaltung wird nachstehend an der ersten Schaltstrecke erläutert.

Am Ausgang einer mit IC angedeuteten integrierten Schaltung in PLL-Technik liegt ein Operationsverstärker OP, an dessen Ausgang die Abstimmspannung VT abnehmbar ist, die einem Tuner T zugeführt wird. Vom Ausgang des Operationsverstärkers OP ist eine Gegenkopplung, bestehend aus dem Widerstand $R_0$, $C_0$, $C_1$ auf den invertierenden Eingang des Operationsverstärkers OP eingefügt. Über den Widerstand $R_v$ liegt der Ausgang an einer stabilisierten Spannung von z. B. +33 V. Parallel zum Widerstand R0 ist an die Abstimmspannung VT ein Widerstand R1 über die Reihenschaltung zweier Dioden D11 und D12 parallel geschaltet. Die Dioden D11 und D12 sind mit ihren Anoden verbunden, welche an einen aus den Widerstand R11 und R12 gebildeten Spannungsteiler geschaltet sind der zwischen die Spannungsquelle +33 V und Bezugspotential geschaltet ist. Die sich bildende Vorspannung U1 für die Dioden D11 und D12 ist derart gewählt , daß sie im unteren Abstimmspannungsbereich, d. h. bei steilem Verlauf der Kapazitätsdiodencharakteristik, leitend sind. Bei einem Abstimmspannungswert VT unterhalb dieser Vorspannung U1 ist demnach der Widerstand R1 dem Widerstand R0 parallel geschaltet. Durch dieses Parallelschalten des Widerstandes R1 wird die Rückkopplungsimpedanz des Operationsverstärkers OP verringert, wodurch in dem Teil des Abstimmspannungsbereichs mit steilem Verlauf und damit großer Frequenzänderung bei gleichen Abstimmspannungsschritten die Rückkopplung erhöht wird. Hierdurch wird die PLL-Schleife im unteren Abstimmspannungsbereich, in welchem kleine Spannungsänderungen große Frequenzänderungen zur Folge haben, stabilisiert. Durch stärkere Gegenkopplung wird einer Instabilität der Regelung des PLL-Systems entgegengewirkt. Die Erzeugung der Vorspannung U1 für die Dioden D11 und D12 werden von der gleichen stabilisierten Spannung +33 V abgeleitet, von der auch die Abstimmspannung VT abhängt. Dadurch ist die Umschaltung der Gegenkopplung und damit der Zeitkonstanten des Tiefpasses nur von der Abstimmspannung VT abhängig und andere Spannungsschwankungen haben keinen Einfluß.

## Patentansprüche

1. Schaltungsanordnung zum Abstimmen von Hochfrequenzempfängern mit Hilfe einer Phase-locked-loop-Schaltung zur Erzeugung der Abstimmspannung (VT) für die Kapazitätsdioden in den HF-Abstimmkreisen (T) sowie einer Anordnung, die in Abhängigkeit von der Abstimmung die Zeitkonstante und damit die Bandbreite des Tiefpassfilters ($R_0$, $C_0$, $C_1$) in der Phase-locked-loop-Schaltung umschaltet, dadurch gekennzeichnet, daß ein Widerstand (R1) mit seinem einen Ende mit der Abstimmspannung (VT) verbunden ist und mit seinem anderen Ende über zwei mit ihren Anoden verbundenen Dioden (D11, D12) mit dem von der Abstimmspannung (VT) abgewandten Ende eines Widerstandes (R0) des Tiefpassfilters ($R_0$, $C_0$, $C_1$) verbunden ist und daß die Anoden der Dioden (D11, D12) über einen eine Vorspannung (U1) erzeugenden Spannungsteiler (R11, R12) in der Weise vorgespannt sind, daß sie bei einer unterhalb der Vorspannung (U1) liegenden Abstimmspannung (VT) leitend sind, sodaß der Widerstand (R1) nach Unterschreiten der der Abstimmspannung (VT) unter den durch die Vorspannung (U1) gegebenen Wert über eine der Dioden (D11, D12) dem Widerstand ($R_0$) des Tiefpassfilters ($R_0$, $C_0$, $C_1$) parallel geschaltet ist und daß die Abstimmspannung (VT) und die Vorspannung (U1) von der gleichen Spannungsquelle (+33 V) abgeleitet sind.

2. Schaltungsanordnung nach Anspruch 1, dadurch gekennzeichnet, daß die Umschaltung in der Weise erfolgt, daß in Abhängigkeit von der Abstimmlage der Kapazitätsdioden-Charakteristik mit zunehmender Steilheit auf der Abstimmkurve der Grenzfrequenz des Tiefpassfilters zu höheren Werten umgeschaltet wird und umgekehrt.

3. Schaltungsanordnung nach Anspruch 1 und 2, dadurch gekennzeichnet, daß mehrere in Reihe geschaltete Widerstände (R1 - Rn) vorgesehen sind, die in Abhängigkeit der abnehmenden Abstimmspannung (VT) nacheinander von mittels Spannungsteilern (11, R12; R21; R22 - Rn1, Rn2) vorgespannten Dioden (D11, D12 - Dn1, Dn2) dem Widerstand (R$_0$) des Tiefpassfilters der Phase-locked-loop-Schaltung parallel geschaltet sind.

## Claims

1. A circuit arrangement for tuning high frequency receivers with the help of a phase-locked-loop circuit for producing the tuning voltage (VT) for the capacitance diodes in the HF tuning circuits (T), and an arrangement which switches over the time constant, and thus the bandwidth, of the low-pass filter (R$_0$, C$_0$, C$_1$) in the phase-locked-loop circuit as a function of the tuning, characterised in that a resistor (R1) is connected at one end to the tuning voltage (VT) and is connected at its other end via two diodes (D11, D12) to the end of a resistor (R$_0$) of the low-pass filter (R$_0$, C$_0$, C$_1$), which end is opposite to the tuning voltage (VT), and in that the anodes of the diodes (D11, D12) are biassed by means of a voltage divider (R11, R12) producing a bias voltage (U1) in such a way that they are conductive at a tuning voltage (VT) which is less than the bias voltage (U1), so that the resistor (R1) is switched in parallel to the resistor (R$_0$) of the low-pass filter (R$_0$, C$_0$, C$_1$) via one of the diodes (D11, D12) when the value given to the tuning voltage (VT) falls below that given by the bias voltage (U1), and that the tuning voltage (VT) and the bias voltage (U1) are derived from the same voltage source (+33 V).

2. A circuit arrangement according to Claim 1, characterised in that the switch-over takes place so that as a function of the tuning position of the capacitance diode characteristic curve, the limiting frequency of the low-pass filter is switched over to higher values with increasing steepness on the tuning curve.

3. A circuit arrangement according to Claims 1 and 2, characterised in that several, serially connected resistors (R1 - Rn) are provided, which are connected in parallel, one after the other, to the resistor (R$_0$) of the low-pass filter of the phase-locked-loop circuit as a function of the decreasing tuning, voltage (VT) by diodes (D11, D12 - Dn1, Dn2) biassed by means of voltage dividers (11, R12,; R21, R22 - Rn1, Rn2).

## Revendications

1. Montage pour accorder des récepteurs à haute fréquence à l'aide d'un circuit formant boucle de verrouillage de phase pour la production de la tension d'accord (VT) pour les diodes capacitives situées dans les circuits d'accord HF (T) ainsi qu'un dispositif qui commute, en fonction du réglage d'accord, la constante de temps et par conséquent la largeur de bande du filtre passe-bas (R$_0$, C$_0$, C$_1$) situé dans le circuit formant boucle de verrouillage de phase, caractérisé en ce qu'une résistance (R1) est reliée par l'une de ses extrémités à la tension d'accord (VT) et par son autre extrémité à une extrémité, tournée à l'opposé de la tension d'accord (VT), d'une résistance (R0) du filtre passe-bas (R$_0$, C$_0$, C$_1$), par l'intermédiaire de deux diodes (D11, D12) reliées par leurs anodes, et que les anodes des diodes (D11, D12) sont polarisées par l'intermédiaire d'un diviseur de tension (R11, R12) produisant une tension de polarisation (U1), de telle sorte que ces diodes sont conductrices dans le cas d'une tension d'accord (VT) inférieure à la tension de polarisation (U1) de sorte que, une fois que la tension d'accord (VT) est tombée au-dessous de la valeur déterminée par la tension de polarisation (U1), la résistance (R1) est branchée en parallèle avec la résistance (R$_0$) du filtre passe-bas (R$_0$, C$_0$, C$_1$) par l'intermédiaire de l'une des diodes (D11, D12), et que la tension d'accord (VT) et la tension de polarisation (U1) sont dérivées de la même force de tension (+33 V).

2. Montage selon la revendication 1, caractérisé en ce que la commutation s'effectue de telle sorte que la fréquence limite du filtre passe-bas est commutée vers des valeurs supérieures en fonction de la position d'accord de la caractéristique des diodes capacitives lorsque la pente de la courbe d'accord augmente, et inversement.

3. Montage suivant les revendications 1 et 2, caractérisé en ce qu'il est prévu plusieurs résistances (R1 - Rn) qui sont branchées en série et qui, en fonction de la diminution de la tension d'accord (VT), sont branchées successivement en parallèle avec la résistance (R$_0$) du filtre passe-bas du circuit formant boucle de verrouillage de phase, par des diodes (D11, D12 - Dn1, Dn2) polarisées au moyen de diviseurs de tension (R11, R12 ; R21, R22 - Rn1, Rn2).

Fig. 1

Fig. 2

Fig.3